# EUROPEAN PATENT SPECIFICATION

(11) **EP 3 287 273 B1**
(45) Date of publication and mention of the grant of the patent: **06.05.2020**
(21) Application number: 16783194.0
(22) Date of filing: 20.04.2016
(51) Int. Cl.: B32B 9/00, B29C 55/12, B32B 7/02, B32B 27/36, B65D 65/40, C23C 14/08, B29K 67/00, B29L 7/00, C08J 7/06

(54) **BIAXIALLY STRETCHED POLYESTER FILM**
BIAXIAL GESTRECKTE POLYESTERFOLIE
FILM POLYESTER ÉTIRÉ BI-AXIALEMENT

(30) Priority: 24.04.2015 JP 2015089099
(43) Date of publication of application: 28.02.2018
(73) Proprietor: TOYOBO CO., LTD., Osaka-shi, Osaka 530-8230 (JP)
(72) Inventor: GOTO, Takamichi, Inuyama-shi Aichi 484-8508 (JP); HAYASHIBARA, Mikiya, Inuyama-shi Aichi 484-8508 (JP); NAKAYA, Tadashi, Inuyama-shi Aichi 484-8508 (JP); IKEHATA, Yoshitomo, Inuyama-shi Aichi 484-8508 (JP)
(74) Representative: Vossius & Partner Patentanwälte Rechtsanwälte mbB
(86) International application number: PCT/JP2016/062516
(87) International publication number: WO 2016/171173

(56) References cited:
- EP-A1- 2 623 318
- EP-A1- 3 069 849
- EP-A1- 3 147 313
- EP-A1- 3 287 258
- WO-A1-2014/077197
- JP-A- 2011 148 090
- JP-A- 2013 082 942
- JP-A- 2013 256 047

## Description

### TECHNICAL FIELD

The present invention relates to a biaxially stretched polyester film having film strength, impact resistance, transparency, and excellent linearly tearing property, and particularly, relates to a biaxially stretched polyester film that can be particularly suitably used for retort pouch packaging and packaging for water containing material.

### BACKGROUND ART

A polybutylene terephthalate resin (hereinafter, referred to as PBT resin) is excellent in gas barrier property and chemical resistance, in addition to mechanical properties and impact resistance, and thus has conventionally been used as an engineering plastic, in particular, as a useful material owing to good productivity attributed to crystallization rate. In addition, an unstretched PBT resin film has been used in film fields such as converting films, films for food package and drawing films, from the viewpoint of using its characteristics. In recent years, a PBT resin with further improved mechanical properties and impact resistance is required, and in order to draw out the original characteristics of the PBT resin, a film obtained by biaxially stretching the PBT resin has been studied, and further a film provided with an inorganic thin film layer on the biaxially stretched film is required.

For example, Patent Document 1 discloses a gas barrier film that is a packaging material containing a biaxially stretched PBT-based film including either at least a PBT resin or a polyester-based resin composition in which a polyethylene terephthalate resin is blended in a range of not more than 30% by weight to the PBT resin. The gas barrier film is vapor-deposited with an inorganic thin film such as aluminum or aluminum oxide and has flex pinhole resistance and impact resistance when the number of pinholes after the barrier film is bent 1000 times under a condition of 5°C × 40% RH is not more than 10.

However, in the technique according to Patent Document 1, the film forming method by tubular simultaneous biaxial stretching is poor in thickness accuracy due to its production method, and thus has been insufficient for use in the vapor deposition film. The gas barrier film is inferior in impact resistance because the plane orientation coefficient is not increased. Therefore, there has been still room for improvement in order to obtain moisture resistance, pinhole resistance and bag breakage resistance.

On the other hand, for example, Patent Document 2 and Patent Document 3 disclose that a biaxially stretched PBT film having excellent thickness accuracy, excellent impact resistance and piercing resistance is obtained by increasing the degree of plane orientation with sequential biaxial stretching of an unstretched polyester sheet having a thickness of 15 to 2500 µm, the sheet being multi-layered with the same composition of not less than 60 layers and then subjected to casting.

However, the biaxially stretched PBT film obtained by these methods has a problem that it cannot be linearly torn when tearing the film in the longitudinal direction due to distortion generated in the orientation main axis of molecule in the width direction during biaxial stretching. Therefore, packaging bags made of the film have poor linearly tearing property when opened by hand, and there has been a possibility that scattering or breakage of contents occurs when opened.

Patent Document 4 discloses, as a method for improving linearly tearing property, a simultaneously biaxial stretching method in the mechanical and transverse direction using a PBT resin composition in which a polyester-based elastomer is blended in a range of 1 to 20% by weight to a PBT resin that is a main raw material under specific stretching conditions, similarly to a biaxially stretched PBT film.

However, in the method for improving tearability by the addition of a polyester-based elastomer as in these techniques, a polyester-based elastomer having low compatibility with PBT is used, so that not only the transparency is impaired but also the strength is lowered due to the addition of a component having low strength. Accordingly, there has been not only a drawback that the original merit of PBT cannot be sufficiently drawn out, but also a gas barrier property has not been sufficiently obtained even when provided with an inorganic thin film layer.

### PRIOR ART DOCUMENT

### PATENT DOCUMENTS

Patent Document 1: JP-A-2014-043296
Patent Document 2: JP-A-2013-256110
Patent Document 3: WO 2014/077197 A
Patent Document 4: JP-A-2013-091693

### SUMMARY OF THE INVENTION

### PROBLEMS TO BE SOLVED BY THE INVENTION

The present invention has been made in view of the problems on the conventional technology. More specifically, an object of the present invention is to provide a biaxially stretched polyester film that is excellent in linearly tearing property while maintaining film strength, impact resistance and transparency, and in particularly, that can be particularly suitably used for retort pouch packaging and packaging for water containing material.

### SOLUTIONS TO THE PROBLEMS

As a result of intensive study to achieve the above object, the present inventors have completed the present invention.

The present invention is a gas barrier film comprising: a biaxially stretched polyester film including a thermoplastic resin composition containing not less than 60% by weight of polybutylene terephthalate, a polyester resin other than the PBT resin such as polyethylene terephthalate (PET), polyethylene naphthalate (PEN), polybutylene naphthalate (PBN) or polypropylene terephthalate (PPT), and a resin selected from PBT resins copolymerized with a dicarboxylic acid such as isophthalic acid, orthophthalic acid, naphthalenedicarboxylic acid, biphenyldicarboxylic acid, cyclohexanedicarboxylic acid, adipic acid, azelaic acid or sebacic acid, and simultaneously satisfying conditions (1) to (3) below, and an inorganic thin film layer on at least one side of the biaxially stretched polyester film:
(1) an angle formed by a molecular chain main axis with respect to a TD direction of the film is not more than 30°,
(2) each thermal shrinkage at 150°C in the film longitudinal direction and the film width direction is not more than 4.0%, and
(3) the film has an intrinsic viscosity of not less than 0.80 dl/g and not more than 1.2 dl/g.

In this case, it is preferable that the inorganic thin film layer is an inorganic oxide vapor-deposited film.

Furthermore, in this case, it is preferable that the inorganic thin film layer is a layer formed of a composite oxide of silicon oxide and aluminum oxide.

### EFFECT OF THE INVENTION

The present inventors can obtain a biaxially stretched polyester film having film strength, impact resistance, transparency, and excellent linearly tearing property, and particularly, a biaxially stretched polyester film that can be particularly suitably used for retort pouch packaging and packaging for water containing material.

In the present invention, a component that impairs the transparency of a film, such as a polyester elastomer, is not added, and thus the obtained film has particularly excellent transparency.

### MODE FOR CARRYING OUT THE INVENTION

Hereinafter, the present invention will be described in detail.

A polyester thermoplastic resin composition used in the present invention contains a PBT resin as a main constituent component, and the content of the PBT resin is preferably not less than 60% by mass, further preferably not less than 70% by mass, and further preferably not less than 90% by mass. When the content is less than 60% by mass, the impact strength and the pinhole resistance are lowered and film characteristics become insufficient.

In the PBT resin used as a main constituent component, terephthalic acid as a dicarboxylic acid component is used in an amount of preferably not less than 90 mol%, more preferably not less than 95 mol%, further preferably not less than 98 mol%, and most preferably 100 mol%. As a glycol component, 1,4-butanediol is used in an amount of preferably not less than 90 mol%, more preferably not less than 95 mol%, and further preferably not less than 97 mol%, and most preferably, no other than byproducts produced by ether linkage of 1,4-butanediol at the time of polymerization is contained.

The polyester thermoplastic resin composition to be used in the present invention can contain a polyester resin other than PBT resins for the purpose of adjusting the film formability at the time of performing biaxial stretching and the mechanical characteristics of the film to be obtained.

Examples of the polyester resin other than PBT resins include polyester resins such as polyethylene terephthalate (PET), polyethylene naphthalate (PEN), polybutylene naphthalate (PBN), and polypropylene terephthalate (PPT), as well as PBT resins copolymerized with dicarboxylic acids such as isophthalic acid, orthophthalic acid, naphthalenedicarboxylic acid, biphenyldicarboxylic acid, cyclohexanedicarboxylic acid, adipic acid, azelaic acid, and sebacic acid. The amount of the component to be copolymerized in the copolymerized PBT resin is not less than 5 wt% with respect to the whole PBT resins. However, those containing polyalkylene oxide are not suitable.

The upper limit of the amount of the polyester resin added other than PBT resins is preferably not more than 40% by mass, more preferably not more than 30% by mass, further preferably not more than 10% by mass, and particularly preferably not more than 5% by mass. If the amount of the polyester resin added other than PBT resins is more than 40% by mass, the mechanical characteristics as PBT resins may be impaired, the impact strength, the bag breakage resistance and the pinhole resistance may become insufficient, and further the transparency and the barrier property may be lowered, and the like.

The lower limit of the intrinsic viscosity of the PBT resin used in the present invention is preferably 0.8 dl/g, more preferably 0.95 dl/g, and further preferably 1.0 dl/g.

If the intrinsic viscosity of the PBT resin as the raw material is less than 0.9 dl/g, the intrinsic viscosity of the film obtained by film formation is lowered, and the piercing strength, the impact strength, the bag breakage resistance and the like may be lowered.

The upper limit of the intrinsic viscosity of the PBT resin is preferably 1.3 dl/g. If the intrinsic viscosity is more than the above value, the stress at the time of stretching may become too high and the film forming property may deteriorate.

The upper limit of the amount of the polyester resin added other than PBT resins is preferably not more than 10% by mass, and more preferably not more than 5% by mass. If the amount of the polyester resin added other than PBT resins is more than 10% by mass, the mechanical characteristics as PBT resins may be impaired, the impact strength, the bag breakage resistance and the pinhole resistance may become insufficient, and further the transparency and the barrier property may be lowered, and the like.

The lower limit of the melting temperature of the polyester-based thermoplastic resin composition is preferably 200°C, and if the melting temperature is less than 200°C, the discharge may become unstable. The upper limit of the melting temperature of the resin is preferably 300°C, and if the melting temperature is more than 300°C, the deterioration of PBT resin may occur.

The above-mentioned polyester-based thermoplastic resin composition may contain conventionally known additives, for example, a lubricant, a stabilizer, a coloring agent, an antioxidant, an anti-static agent, an ultraviolet absorber, and the like, as necessary.

As a lubricant, inorganic lubricants such as silica, calcium carbonate and alumina, as well as organic lubricants are preferable, silica and calcium carbonate are more preferable, and among them, silica is particularly preferable from the viewpoint of reducing haze. These lubricants provide transparency and slippage in the film.

The lower limit of the concentration of the lubricant in the polyester-based thermoplastic resin composition is preferably 100 ppm, and if the concentration is less than 100 ppm, the slippage may be lowered. The upper limit of the concentration of the lubricant is preferably 20000 ppm, and if the concentration is more than 20000 ppm, the transparency may be lowered.

The lower limit of the intrinsic viscosity of the present film is preferably 0.80 dl/g, more preferably 0.85 dl/g, further preferably 0.90 dl/g, and particularly preferably 0.95 dl/g. When the intrinsic viscosity is not less than the above value, the piercing strength, the impact strength, the bag breakage resistance and the like are improved. In addition, the barrier property after bending is also good.

The upper limit of the intrinsic viscosity of the film is preferably 1.2 dl/g, and further preferably 1.1 dl/g. When the intrinsic viscosity is more than the above value, the stress at the time of stretching does not become too high, and the film formability becomes favorable.

The upper limit of the orientation axis angle of the present film is preferably 30°, more preferably 28°, and further preferably 25°. This makes the linearly tearing property favorable, and it is easy to tear the film in the intended direction because it is possible to reduce parting at the time of opening in the longitudinal direction of the film when formed into a packaging bag.

The reason is not clear why the linearly tearing property in the longitudinal direction is excellent; however, when the orientation angle of the molecular chain main axis is not more than 30° with respect to the main orientation direction of the polyester film, the difference in the orientation directions of the molecular chain main axes in the polyester films on the front and back sides forming a packaging bag can be reduced, so that it is presumed that parting of the polyester film is small and the film is excellent in linearly tearing property.

Conventionally, the phenomenon in which the orientation angle of the molecular chain main axis is more than 20° may be observed in a film that is, particularly in sequential biaxial stretching system, slit (cut) from a portion close to the end part in the width direction gripped by clips when stretching the film in the longitudinal direction, and then stretching the film in the width direction using a tenter.

In order to reduce the orientation angle of the molecular chain main axis, there can be mentioned an increase in the mechanical stretching direction (hereinafter, MD) stretching temperature, a decrease in the MD stretching ratio, and a decrease in the transverse stretching direction (hereinafter, TD) relax rate in the film manufacturing process.

The lower limit of the refractive index of the present film in the longitudinal direction is preferably 1.610, more preferably 1.612, and further preferably 1.613. If the refractive index is less than the above value, the orientation is weak, and thus sufficient strength as a film cannot be obtained and the bag breakage resistance may be lowered.

The upper limit of the refractive index of the present film in the longitudinal direction is preferably 1.640, more preferably 1.635, and further preferably 1.630. If the refractive index is more than the above value, the effects of film mechanical characteristics and linearly tearing property may be saturated.

The lower limit of the refractive index of the present film in the width direction is preferably 1.649, more preferably 1.650, and further preferably 1.651. If the refractive index is less than the above value, the orientation is weak, and thus sufficient strength as a film cannot be obtained and the bag breakage resistance may be lowered.

The upper limit of the refractive index of the present film in the width direction is preferably 1.670, more preferably 1.669, and further preferably 1.668. If the refractive index is more than the above value, the effects of film mechanical characteristics and linearly tearing property may be saturated.

In the present film, the difference between the refractive index Nx in the longitudinal direction of the film and the refractive index Nx in the width direction of the film (Nx - Ny) is preferably not more than -0.022, further preferably not more than -0.025, and further preferably not more than -0.03. If the difference is more than the above value, the linearly tearing property in the longitudinal direction of the film may decrease.

The lower limit of the intrinsic viscosity of the present film is preferably 0.8, more preferably 0.85, further preferably 0.9, particularly preferably, and most preferably. If the intrinsic viscosity is less than the above value, the piercing strength, the impact strength, the bag breakage resistance and the like may be lowered. The upper limit of the intrinsic viscosity of the film is preferably 1.2. If the intrinsic viscosity is more than the above value, the stress at the time of stretching may become too high and the film formability may deteriorate.

The biaxially stretched polyester film of the present invention is preferably formed of a resin having the same composition throughout the entire film.

A layer of another material may be on the biaxially stretched polyester film of the present invention, and as a method for lamination, the layer of another material can be stuck after formation of the biaxially stretched polyester film of the present invention or the layer can be stuck during the polyester film formation.

The lower limit of the impact strength J/pm of the present film is preferably 0.055, more preferably 0.060, and further preferably 0.065. If the impact strength is less than the above value, the strength may be insufficient when used as a bag.

The upper limit of the impact strength J/pm is preferably 0.2. If the impact strength is more than the above value, the effect of improvement may be saturated.

The upper limit of the haze (%/pm) per thickness of the present film is preferably 0.35%, more preferably 0.33%, and further preferably 0.31%.

If the haze is more than the above value, there is a possibility that the quality of printed characters and images may be impaired when the film is subjected to printing.

The lower limit of the thermal shrinkage (%) of the present film in each of the longitudinal direction and the width direction is preferably 0. If the thermal shrinkage is less than the above value, the effect of improvement may be saturated, and the film may become brittle in mechanical properties.

The upper limit of the thermal shrinkage (%) of the present film in each of the longitudinal direction and the width direction is preferably 4.0, more preferably 3.5, and further preferably 3.0. If the thermal shrinkage is more than the above value, pitch deviation and the like may occur according to dimensional changes during processing such as printing. In addition, the barrier property after bending tends to be lowered.

In the biaxially stretched film of the present invention, the lower limit of the film thickness is preferably 3 µm, more preferably 5 µm, and further preferably 8 µm. If the film thickness is less than 3 µm, strength as a film may be insufficient.

The upper limit of the film thickness is preferably 100 µm, more preferably 75 µm, and further preferably 50 µm. If the film thickness is more than 100 µm, the film may become too thick so that processing relevant to the aim of the present invention may be difficult.

### (Method for Producing Biaxially Stretched Polyester Film)

A preferred method for obtaining the film according to the present invention includes multi-layering raw materials having the same composition, followed by casting.

Since a PBT resin has a high crystallization rate, crystallization proceeds even at the time of casting. At this time, in the case of casting in monolayering without multi-layering, there is no barrier that can suppress crystal growth, and thus the crystals are grown to be spherulites having large size. As a result, the obtained unstretched sheet has high yield stress and is easy to be broken at the time of biaxial stretch, so that the obtained biaxially stretched film has impaired flexibility and insufficient pinhole resistance and bag breakage resistance.

Meanwhile, the present inventors have found that the stretching stress of an unstretched sheet can be lowered and stable biaxial stretch is made possible by laminating the same resin in multi-layering manner.

Specifically, the method for producing a biaxially stretched polyester film of the present invention includes at least the following steps of: Step (1) melting a thermoplastic resin composition containing not less than 90% by weight of a polybutylene terephthalate resin to form a molten fluid; Step (2) forming a laminated fluid having the number of lamination of not less than 60 including the molten fluid formed in Step (1); Step (3) discharging the laminated fluid formed in Step (2) from a die and bringing the discharged into contact with a cooling roll to be solidified so that a laminate is formed; and Step (4) biaxially stretching the laminate.

There may be no problem even if other steps are inserted between Step (1) and Step (2) as well as between Step (2) and Step (3). For example, a filtration step, a temperature change step and the like may be inserted between Step (1) and Step (2). Besides, a temperature change step, a charge addition step and the like may be inserted between Step (2) and Step (3). However, there should not be a step of breaking the laminated structure formed in Step (2) between Step (2) and Step (3).

In Step (1), the method of melting a thermoplastic resin of the present invention to form a molten fluid is not particularly limited, and a preferred method includes a method of melting a thermoplastic resin under heat using a single screw extruder or twin screw extruder.

The method of forming a laminated fluid in Step (2) is not particularly limited, but from the viewpoint of facility simplicity and maintainability, a static mixer and/or a multi-layer feed block is more preferable. Also, from the viewpoint of uniformity in the sheet width direction, one having a rectangular melt line is more preferable. It is further preferred to use a static mixer or a multi-layer feed block having a rectangular melt line. A resin composition composed of a plurality of layers formed by combining a plurality of resin compositions may be passed through one or more of a static mixer, a multi-layer feed block and a multi-layer manifold.

The theoretical number of lamination in Step (2) needs to be not less than 60. The lower limit of the theoretical number of lamination is preferably 200 and more preferably 500. If the theoretical number of lamination is too small, the effect of accelerating the crystallization is insufficient, or alternatively, the distance between the layer interfaces becomes long and the crystal size tends to be too large, so that the effect of the present invention tends not to be obtained. In addition, the transparency after molding may decrease in the vicinity of both ends of the sheet. The upper limit of the theoretical number of lamination in Step (2) is not particularly limited, and is preferably 100000, more preferably 10000, and further preferably 7000. Even when the theoretical number of lamination is extremely increased, the effect is saturated, and further problems may arise in terms of production efficiency.

When the lamination in Step (2) is performed by a static mixer, the theoretical number of lamination can be adjusted by selecting the number of elements of the static mixer. A static mixer is generally known as a stationary mixer without a driving part (line mixer), and a fluid entering the mixer is sequentially stirred and mixed by elements. However, when a high viscosity fluid is passed through a static mixer, splitting and lamination of the high viscosity fluid occur, and a laminated fluid is formed. The high viscosity fluid is divided into two parts every time the fluid passes through one element of the static mixer, then joined together and laminated. Therefore, when a high viscosity fluid is passed through a static mixer having the number of elements n, a laminated fluid having a theoretical number of lamination N of 2n is formed. It is also possible to use a laminated fluid as the high viscosity fluid to be supplied to the static mixer. When the number of lamination of the high viscosity fluid supplied to the static mixer is m, the theoretical number of lamination N of the laminated fluid is N = m × 2n.

A typical static mixer element has a structure in which a rectangular plate is twisted by 180 degrees, and there are a right element and a left element depending on the twisting direction. The dimension of each element is 1.5 times the length with respect to the diameter. The static mixer that can be used in the present invention is not limited to those described above.

When the lamination in Step (2) is performed by a multi-layer feed block, the theoretical number of lamination can be adjusted by selecting the number of times of division and lamination of the multi-layer feed block. It is possible to install a plurality of multi-layer feed blocks in series. It is also possible to use, as a laminated fluid, a high viscosity fluid itself supplied to the multi-layer feed block. For example, when the number of lamination of the high viscosity fluid supplied to the multi-layer feed block is p, the number of division and lamination of the multi-layer feed block is q, and the number of the multi-layer feed blocks installed is r, the number of lamination N of the laminated fluid is N = p × qr.

In Step (3), the laminated fluid is discharged from a die and brought into contact with a cooling roll to be solidified.

The lower limit of the die temperature is preferably 200°C, and if the temperature is less than the above value, the discharge may become unstable and the thickness may become uneven. The upper limit of the die temperature is preferably 320°C, and if the temperature is more than the above value, the thickness may become uneven, resin deterioration may be caused, and further the appearance may become inferior because of staining of die lips and the like.

The lower limit of the temperature of the cooling roll is preferably 0°C, and if the temperature is less than the above value, the crystallization suppression effect may be saturated. The upper limit of the temperature of the cooling roll is preferably 25°C, and if the temperature is more than the above value, the crystallization degree may become so high that the stretching may be difficult. Further, when the temperature of the cooling roll is controlled to be within the above range, it is preferable to lower the humidity of the environment in the vicinity of the cooling roll for preventing dew formation.

In the casting, the temperature of the cooling roll surface is increased since the resin with high temperature is brought into contact with the surface. Usually, a chill roll is cooled by setting a pipe in the inside of the roll and passing cooling water therethrough, and it is necessary to reduce the temperature difference in the width direction of the chill roll surface by securing a sufficient amount of cooling water, devising the arrangement of the pipe, performing maintenance so that sludge does not adhere to the pipe, and the like. In particular, attention should be paid when cooling the resin at low temperature without using a multi-layered method or the like.

At this time, the thickness of the unstretched sheet is preferably in the range of 15 to 2500 µm.

The casting in the above-described multi-layer structure is performed in at least 60 layers, preferably not less than 250 layers, and further preferably not less than 1000 layers. If the number of layers is small, the spherulite size of the unstretched sheet becomes large, so that not only the effect of improving stretchability is small, but also the effect of lowering the yield stress of the obtained biaxially stretched film is lost.

Next, a stretching method will be described. A stretching method can be either a simultaneous biaxial stretching method or a sequential biaxial stretching method, and for increasing the piercing strength, it is necessary to increase the plane orientation coefficient in the biaxially stretched polybutylene terephthalate film of the present invention, and therefore a sequential biaxial stretching method is preferred in this respect.

The lower limit of the stretching temperature in the mechanical stretching direction (hereinafter, MD) is preferably 55°C, and more preferably 60°C. If the temperature is less than 55°C, not only film-breaking may easily occur, but also the orientation in the mechanical direction becomes strong due to stretching at low temperature, so that the shrinkage stress during heat-setting treatment increases, and thus the distortion of molecular orientation in the width direction increases. Consequently, linearly tearing property in the longitudinal direction may decrease. The upper limit of the MD stretching temperature is preferably 100°C, and more preferably 95°C. If the temperature is more than 100°C, mechanical characteristics may be deteriorated because no orientation is applied.

When a PET resin is used as a resin other than the PBT resins, it is preferable that the MD stretching temperature is made higher than the case of the PBT resin alone.

The lower limit of the MD stretching ratio is preferably 2.6 times, and particularly preferably 2.8 times. If the MD stretching ratio is less than the above value, there is a possibility that mechanical characteristics and thickness unevenness may be worsened because no orientation is applied. The upper limit of the MD stretching ratio is preferably 4.3 times, more preferably 4.0 times, and particularly preferably 3.8 times. When the MD stretching ratio is more than the above value, not only the effect of improving the mechanical strength and thickness unevenness is saturated, but also the orientation in the mechanical direction becomes stronger, so that the shrinkage stress during the heat-setting treatment increases, and thus the distortion of molecular orientation in the width direction increases. Consequently, linearly tearing property in the longitudinal direction may decrease.

The lower limit of the stretching temperature in the transverse stretching direction (hereinafter, TD) is preferably 60°C, and if the temperature is less than the above value, film-breaking may easily occur. The upper limit of the TD stretching temperature is preferably 100°C, and if the temperature is more than the above value, mechanical characteristics may be deteriorated because no orientation is applied. When a PET resin is used as a resin other than the PBT resins, it is preferable that the TD stretching temperature is made higher than the case of the PBT resin alone.

The lower limit of the TD stretching ratio is preferably 3.5 times, more preferably 3.6 times, and particularly preferably 3.7 times. If the TD stretching ratio is less than the above value, there is a possibility that mechanical characteristics and thickness unevenness may be worsened because no orientation is applied. The upper limit of the TD stretching ratio is preferably 5 times, more preferably 4.5 times, and particularly preferably 4.0 times. If the TD stretching ratio is more than the above value, the effect of improving the mechanical strength and thickness unevenness is saturated.

The lower limit of the TD heat-setting temperature is preferably 200°C, and more preferably 205°C. If the TD heat-setting temperature is less than the above value, thermal shrinkage may become large, and deviation or shrinkage during processing may occur. The upper limit of the TD heat-setting temperature is preferably 250°C, and if the temperature is more than the above value, the film melts, or even when the film does not melt, it may become brittle.

The lower limit of the TD relaxation rate is preferably 0.5%, and if the rate is less than the above value, film-breaking may easily occur during heat-setting. The upper limit of the TD relaxation rate is preferably 5%, and if the rate is more than the above value, not only sagging may occur and result in thickness unevenness, but also shrinkage in the longitudinal direction during heat-setting may become large, and consequently, the distortion of molecular orientation in the end part may become large and linearly tearing property may decrease.

The biaxially stretched polybutylene terephthalate film of the present invention can impart excellent gas barrier properties by forming into a laminated film having a gas barrier layer on at least one side of the film.

As the gas barrier layer to be on the biaxially stretched polybutylene terephthalate film of the present invention, a thin film including a metal or an inorganic oxide is preferably used as an inorganic thin film layer, or a coating layer including a barrier resin such as polyvinylidene chloride is preferably used.

According to the invention the inorganic film layer is an aluminum oxide vapour deposited film. Furthermore, it is also disclosed (i.e. what follows in this paragraph does not fall necessarily into the ambit of the claims) that among the gas barrier layers, an inorganic thin film layer is preferably a thin film including a metal or an inorganic oxide. The material for forming the inorganic thin film layer is not particularly limited as long as the material can be made into a thin film, and from the viewpoint of gas barrier properties, inorganic oxides such as silicon oxide (silica), aluminum oxide (alumina), and mixtures of silicon oxide and aluminum oxide are preferred. In particular, a composite oxide of silicon oxide and aluminum oxide is preferable from the viewpoint of satisfying flexibility and denseness of the thin film layer. In this composite oxide, the mixing ratio of the silicon oxide and the aluminum oxide is preferably in the range of 20 to 70% of Al by the mass ratio of the metal components.

If the Al concentration is less than 20%, the water vapor barrier property may be low. On the other hand, if the Al concentration is more than 70%, the inorganic thin film layer tends to be hard, and the film may be broken during secondary processing such as printing or lamination. Accordingly, the barrier property may be deteriorated. The silicon oxide as used herein is various silicon oxides such as SiO and SiO₂, or a mixture thereof, and the aluminum oxide as used herein is various aluminum oxides such as AlO and Al₂O₃, or a mixture thereof.

The film thickness of the inorganic thin film layer is usually 1 to 800 nm, and preferably 5 to 500 nm. If the film thickness of the inorganic thin film layer is less than 1 nm, it may be difficult to obtain satisfactory gas barrier properties. On the other hand, even when the film thickness is excessively thicker than 800 nm, the effect of improving the gas barrier property along with excessive thickness is not obtained, and it is rather disadvantageous in terms of flex resistance and production cost.

The method for forming the inorganic thin film layer is not particularly limited, and for example, known vapor deposition methods such as physical vapor deposition methods (PVD methods) such as vacuum vapor deposition method, sputtering method and ion plating method, or chemical vapor deposition methods (CVD methods) may be appropriately adopted. Hereinbelow, a typical method of forming the inorganic thin film layer will be described by taking a silicon oxide-aluminum oxide based thin film as an example. For example, in the case of adopting the vacuum evaporation method, a mixture of SiO₂ and Al₂O₃, a mixture of SiO₂ and Al, or the like is preferably used as a vapor deposition material.

Usually, particles are used as these vapor deposition materials, and in this case, the size of each particle is desirably a size that does not change the pressure during vapor deposition, and the preferable particle size is from 1 mm to 5 mm.

For heating, systems such as resistive heating, high frequency induction heating, electron beam heating and laser heating can be adopted. It is also possible to adopt reactive vapor deposition by introducing oxygen, nitrogen, hydrogen, argon, carbon dioxide gas, steam or the like as a reaction gas, or using a means such as ozone addition or ion assist.

Further, film forming conditions such as applying a bias to a body to be vapor-deposited (laminated film to be vapor-deposited), and heating or cooling a body to be vapor-deposited can be arbitrarily changed. The vapor deposition materials, reaction gases, application of a bias to a body to be vapor-deposited, heating/cooling, and the like can be changed as well even when a sputtering method or a CVD method is adopted.

### EXAMPLES

Next, the present invention will be described in more detail by way of examples, but the present invention is not limited to the following examples. A film was evaluated by the following measurement methods.

### [Film Thickness]

The thickness was measured by a method according to JIS-Z-1702.

### [Intrinsic Viscosity of Film]

Each sample was vacuum dried at 130°C all day and all night and thereafter pulverized or cut, and 80 mg of the obtained sample was accurately weighed and dissolved under heat at 80°C for 30 minutes in a mixed solution of phenol/tetrachloroethane = 60/40 (volume ratio). After the total volume was adjusted to 20 ml by the same mixed solution and the measurement was carried out at 30°C.

### [Orientation Axis Angle]

The position of 300 mm from the end of a mill roll of the obtained film having a full width of 4,200 mm was defined as an end part, and film samples of 100 mm square were cut out from the end part and the center part. As to the film samples, the orientation angle of the molecular chain main axis with respect to the film width direction was measured using an MOA-6004 type molecular orientation meter manufactured by Oji Scientific Instruments.

### [Refractive Index of Film]

Ten specimens were sampled from each rolled sample in the width direction. According to JIS K 7142-1996 5.1 (A method), refractive index in the longitudinal direction (nx) and refractive index in the width direction (ny), and were measured for each specimen by using sodium D-ray as a light source and Abbe's refractcmeter.

### [Haze Value Per Film Thickness]

The measurements were made at three different places of the specimen using a haze meter (NDH2000, manufactured by NIPPON DENSHOKU INDUSTRIES CO., LTD.) according to JIS-K-7105, and the numerical value obtained by dividing the average value of the measurement values by the thickness of the film was defined as the haze value per thickness.

### [Parting Distance at End Part]

As an index of the linearly tearing property, the parting distance was measured by the following method.

### (Sample preparation)

The position of 300 mm from the end of a mill roll of the obtained film having a full width of 4,200 mm is defined as an end part, and a polyester film piece having a length of 210 mm in the tearing direction (longitudinal direction) and a width of 50 mm in the perpendicular direction of the tearing direction is cut out from the end part and the center part. A double-sided pressure-sensitive adhesive tape having a width of 10 mm is attached to one short side of the film piece, the film piece is half-folded at the center line, and both short sides are superimposed and bonded to obtain a test piece. Next, a notch with 30 mm is made in the tearing direction at the central part (at 25 mm from both ends) of the superimposed short side of the test piece.

### (Measurement)

The distance between the chucks of a tensile tester (Tensilon RTC-1225A manufactured by Orientec Co., Ltd.) is set to 50 mm, and the two short sides separated by the notch of the sample are attached to the upper and lower chucks, respectively. Next, the chuck is displaced by 130 mm at a rate of 1000 mm/min, and the sample is torn. The deviation amount at a position of 50 mm from the tearing start point of the tear line in the front side film of the paper surface and the tear line in the rear side film of the paper surface of the torn test piece is defined as a parting distance. Each sample was measured 5 times, and the average value thereof was obtained.

### [Impact Strength]

The strength of each film in environments at 23°C against impact punching was measured by using an impact tester manufactured by TOYO SEIKI SEISAKU-SHO, LTD. The tester employed had impact sphere with a diameter of 1/2 inch. The unit was [J/µm].

### [Thermal Shrinkage]

Five films each having a size of 10 mm in width × 150 mm in length were cut out from the mechanical direction and the transverse direction to prepare test pieces.

To each test piece, marking lines were drawn with a spacing of 100 mm ± 2 mm around the center part of the test piece. The distance between the marking lines of the test piece before heating was measured with an accuracy of 0.1 mm.

The test piece was suspended in a hot-air dryer (PHH-202, manufactured by ESPEC CORP.) under no load conditions, and subjected to a heat treatment under heating conditions of 150°C for 15 minutes.

After taking out the test piece from the thermostat and cooling the test piece to room temperature, the same part as measured at the beginning was measured for the length and the width.

The dimensional change rate of each test piece was calculated as a percentage with respect to the initial value of the dimensional change in the mechanical direction and the transverse direction.

The dimensional change rate in each direction was defined as the average of the measured values in that direction.

### [Pinhole Resistance]

Each film according to the present invention which was laminated with LLDPE sealant (manufactured by TOYOBO Co., Ltd., L4102, thickness 40 µm) under dry condition was cut in a size of 20.3 cm (8 inch) × 27.9 cm (11 inch) and the obtained rectangular test film after the cutting was left to stand in the condition of 23°C and 50% RH for 24 hours or more and thus conditioned. Thereafter, each rectangular test film was rolled into a cylindrical form with a length of 20.32 cm (8 inch).

One end of the cylindrical film was fixed in the outer circumference of a disk-like fixed head of a Gelbo flex tester (NO. 901 Model, manufactured by Rigaku Corporation) (according to the standard of MIL-B-131C) and the other end of the cylindrical film was fixed in the outer circumference of a disk-like movable head set on the opposite to the fixed head at 17.8 µm (7 inch) interval.

A bending test was performed by continuously repeating 2000 cycles at 40 cycles/min, each of which was carried out by rotating the movable head at 440° while moving the movable head closer to the fixed bed by 7.6 µm (3.5 inch) along the axis between both heads set on the opposite to each other in parallel, successively moving the movable head forward by 6.4 µm (2.5 inch) without rotating the movable head, executing these movements reversely to turn the movable head back to the initial position. The test was performed at 5°C.

Thereafter, the number of pinholes generated in the portion of the tested film of 17.8 µm (7 inch) × 27.9 µm (11 inch) excluding the parts fixed in the outer circumferences of the fixed head and the movable head was measured (that is, the number of pinholes generated in 497 cm² (77 square inch) was measured).

### [Bag Breakage Resistance]

Each film according to the present invention which was laminated with LLDPE sealant (manufactured by TOYOBO Co., Ltd., L4102, thickness 40 µm) under dry condition was cut in a size of 15 µm square and two pieces were laminated such that the sealant was inside, three sides of the laminates were heat-sealed at the sealing temperature of 160°C and seal width of 1.0 µm, to prepare a package which had inside dimensions of 13 cm and sealed in the three sides.

The package sealed in the three sides was charged with 250 mL of water, other one side was heat-sealed and closed to prepare a package sealed in the four sides and charged with water.

The package sealed in the four sides was dropped from the height of 100 cm on the concrete plate under circumstances of the temperature of 5°C and humidity of 35% RH, to count the dropped number until the breach and the pinhole were generated.

### [Oxygen Permeability]

The oxygen permeability was carried out in accordance with the method prescribed in JIS K7126-2 A using an oxygen transmittance measurement device ("OX-TRAN 2/21"; manufactured by MOCON Inc.) under the conditions of 23°C and 65% RH. In the measurement, the inorganic thin film surface was deemed as an oxygen gas side.

The obtained measurement value of oxygen permeability of not more than 1.5 cc/m² • day was determined as ⊙, the obtained measurement value of oxygen permeability of not more than 3.0 cc/m² • day was determined as ○, and the obtained measurement value of oxygen permeability of more than 3.0 cc/m² • day was determined as ×.

In addition, the oxygen permeability after bending was measured as the oxygen permeability measured value in the same manner as above, after bending in the same manner as in the pinhole resistance test except that bending was repeated for 50 consecutive cycles.

### [Water Vapor Permeability]

The water vapor permeability was measured in accordance with the method prescribed in JIS K7129 B using a water vapor permeability measurement device ("PERMATRAN-W 3/31"; manufactured by MOCON Inc.) under the conditions of 40°C and 90% RH. In the measurement, the inorganic thin film surface was deemed as a high-humidity side.

The obtained measurement value of water vapor permeability of not more than 1.5 g/m² • day was determined as ⊙, the obtained measurement value of water vapor permeability of not more than 3.0 g/m² • day was determined as ○, and the obtained measurement value of water vapor permeability of more than 3.0 g/m² • day was determined as ×.

### [Continuous Film Formability]

The film formability of the biaxially stretched film was evaluated according to the following criteria. With marks of ○ and Δ, productivity was determined to be good.
○: A film could be formed without breaking, and continuous production was possible.
Δ: The film formability was somewhat unstable, and film-breaking rarely occurred, but continuous production was possible.
×: Film-breaking often occurred, and continuous production was difficult.

### [Raw Material Resin]

### (PBT resin; Examples 1, 3 to 11, Comparative Examples 1, 3, and 4)

In the production of films of Examples 1, 3 to 11, Comparative Examples 1, 3, and 4 described later, 1100-211XG (CHANG CHUN PLASTICS CO., LTD., intrinsic viscosity of 1.28 dl/g) was used as a main raw material PBT resin.

### (PBT resin; Example 2)

In the production of the film of Example 2, 1100-211M (CHANG CHUN PLASTICS CO., LTD., intrinsic viscosity of 1.00 dl/g) was used as a main raw material PBT resin.

### (PBT resin; Comparative Example 3)

In the production of the film of Comparative Example 3, 1200-211L (CHANG CHUN PLASTICS CO., LTD., intrinsic viscosity of 0.79 dl/g) was used as a main raw material PBT resin.

### (PET resin; Examples 9 to 11)

In the production of films of Examples 9 to 11 described later, a polyethylene terephthalate resin having an intrinsic viscosity of 0.62 dl/g and including terephthalic acid//ethylene glycol = 100//100 (mol%) was used.

### [Example 1]

A master batch containing a PBT resin and silica particles having an average particle size of 2.4 µm as inactive particles was added, and blended so that the lubricant concentration was 1600 ppm using a single screw extruder. The resulting mixture was melted at 295°C, then the melt line was introduced into a static mixer having 12 elements. Accordingly, the PBT melt body was divided and laminated to obtain a multi-layer melt body formed of the same raw materials. The melt body was casted from a T-die at 265°C and closely stuck to a cooling roll at 15°C by electrostatic adhesion method to obtain an unstretched sheet.

Successively, the unstretched sheet was subjected to 2.8 times roll stretching at 65°C in the mechanical direction and then subjected to 4.0 times stretching at 90°C in the transverse direction by leading the sheet to a tenter. The sheet was subject to a heat tension treatment at 210°C for 3 seconds and to a relaxation treatment by 1% for 1 second. Thereafter, gripping parts at both ends were cut and removed by 10% each to obtain a mill roll of a PBT film having a thickness of 12 µm. The film forming conditions, physical properties and evaluation results of the obtained film were shown in Table 1.

### [Examples 2 to 8]

The same procedures as those in Example 1 were carried out except that the raw material composition and the film forming conditions in Example 1 were changed to the biaxially stretched films shown in Table 1.

### [Examples 9 to 11]

The same procedures as those in Example 1 were carried out except that the raw material composition and the film forming conditions in Example 1 were changed to the biaxially stretched films shown in Table 2.

### [Comparative Examples 1 to 3]

Films were obtained using a single screw extruder under the conditions shown in Table 3. The film forming conditions, physical properties and evaluation results of the obtained film were shown in Table 3.

### [Comparative Example 4]

To the 80 wt% PBT in each of Examples 1 to 8 was added 20% by weight of a polyester-polyester block copolymer "Pelprene S1001" (manufactured by TOYOBO Co., Ltd.) as a polyester elastomer component for imparting linearly tearing property, and film formation was carried out under the conditions shown in Table 3.

### [Formation of Alumina Thin Film Layer (Vapor Deposition)]

An aluminum oxide (alumina) thin film layer was formed on one side of each of the films obtained in Examples 1, 2 and Comparative Example 2 by reactive vapor deposition, using an aluminum metal as a vapor deposition raw material and introducing oxygen gas as an oxidation gas. The film thickness of the alumina thin film layer in the obtained film (alumina thin film layer/coating layer-containing film) was 15 nm.

### [Formation of Silica-Alumina Thin Film Layer (Vapor Deposition)]

A composite inorganic oxide layer of silicon dioxide and aluminum oxide was formed as an inorganic thin film layer on one side of each of the films obtained in Examples 3 to 8 and Comparative Examples 3 and 4 by an electron beam vapor deposition method. Particulate SiO₂ (purity 99.9%) and Al₂O₃ (purity 99.9%) having a diameter of about 3 mm to 5 mm were used as a vapor deposition source. Here, the composition of the composite oxide layer was SiO₂/Al₂O₃ (mass ratio) = 60/40. The film thickness of the inorganic thin film layer (SiO₂/Al₂O₃ composite oxide layer) in the film (inorganic thin film layer/coating layer-containing film) thus obtained was 13 nm.

As shown in Tables 1 and 2, the gas barrier films (Examples 1 to 11) obtained according to the present invention had excellent oxygen barrier properties and water vapor barrier properties by controlling the intrinsic viscosity and thermal shrinkage of the film. Further, the obtained biaxially stretched PBT films had excellent linearly tearing property in the longitudinal direction at both the end part and the center part, and were simultaneously excellent in the pinhole resistance and the bag breakage resistance by controlling an angle formed by the molecular chain main axis with respect to the TD direction of the film.

On the other hand, as shown in Table 3, the impact strength, pinhole resistance and bag breakage resistance of the film were deteriorated due to the low intrinsic viscosity of the film in Comparative Example 2, and although the distortion of the molecular chain axis was controlled, the thermal shrinkage was high due to the low heat treatment temperature in Comparative Example 3.

In Comparative Example 4, not only transparency and strength were deteriorated due to the effect of adding a polyester elastomer in order to improve tearability, but also deterioration of barrier properties after the vapor deposition of the inorganic thin film was observed.

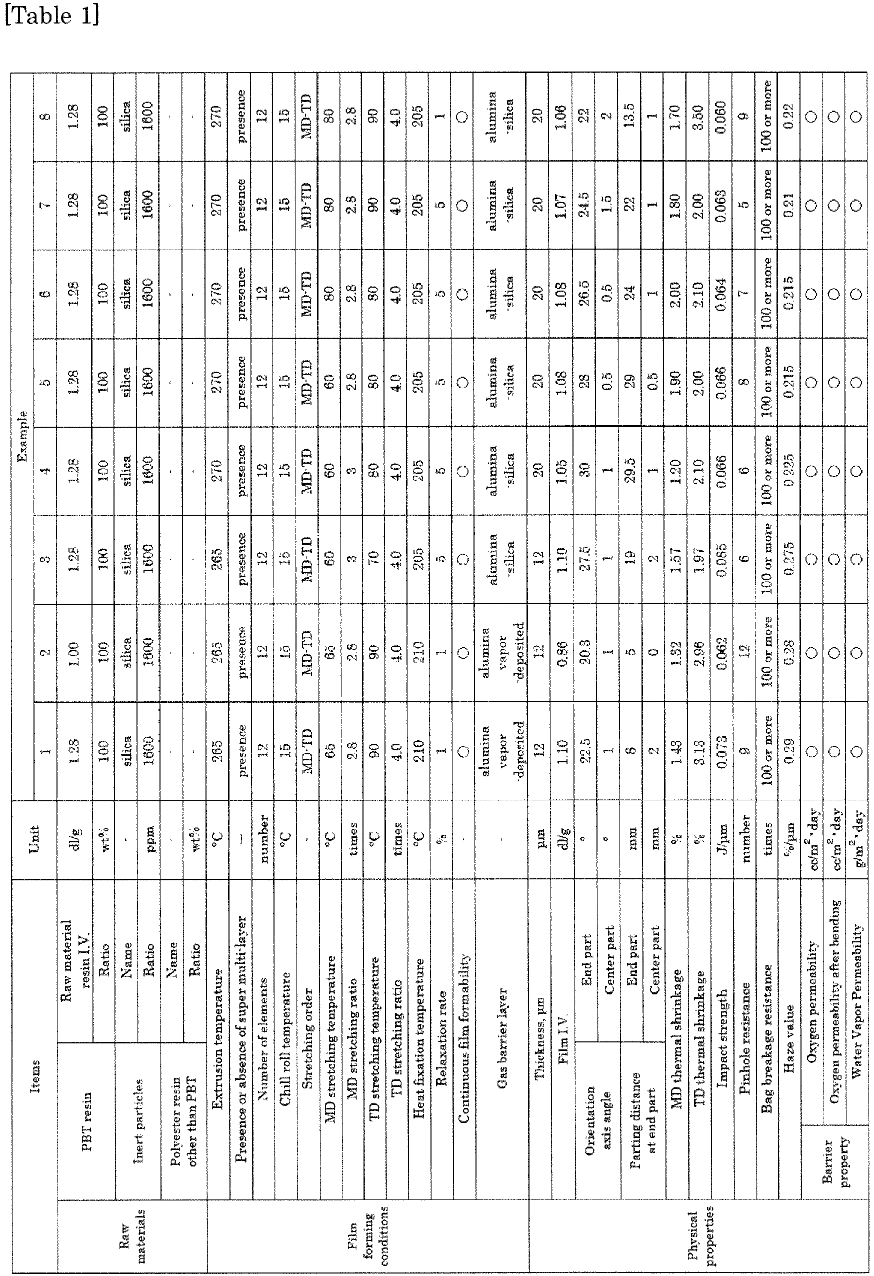

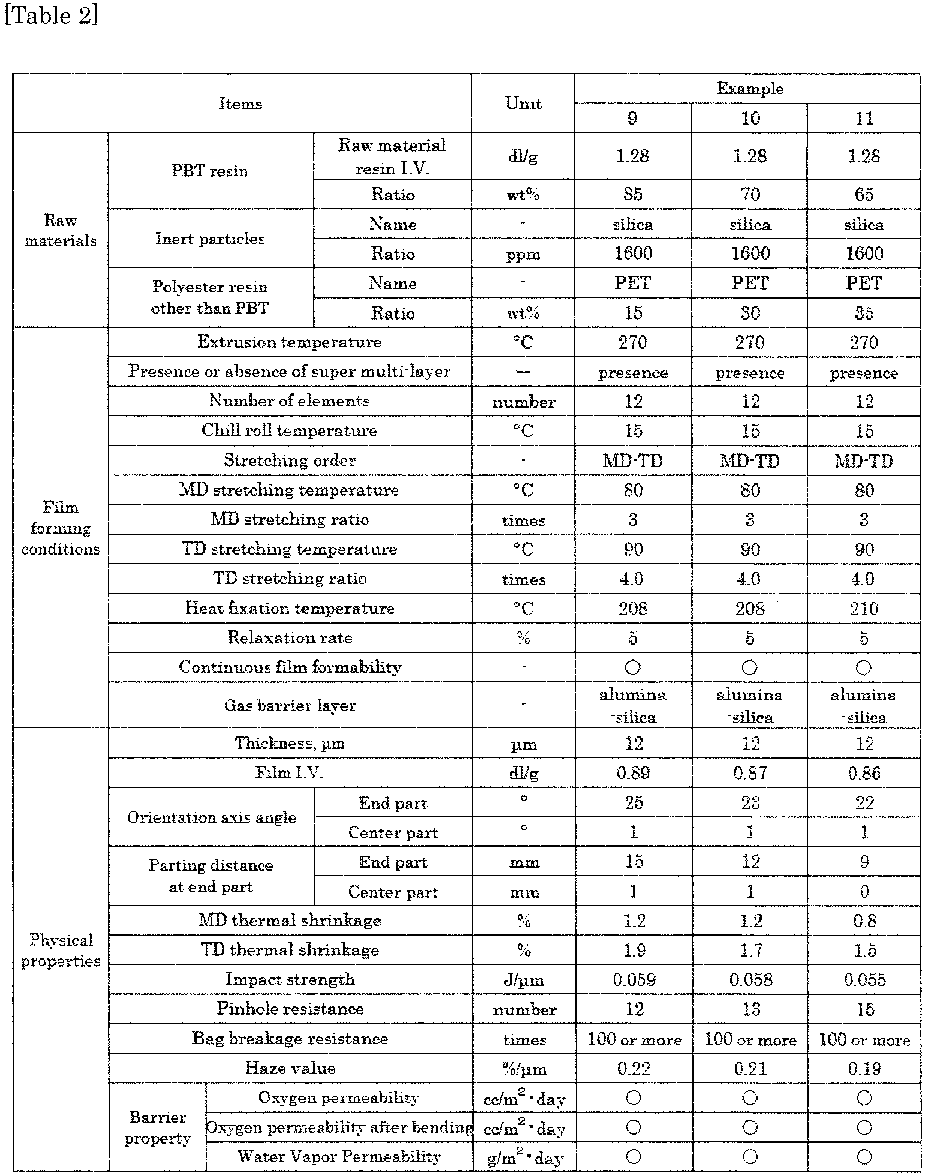

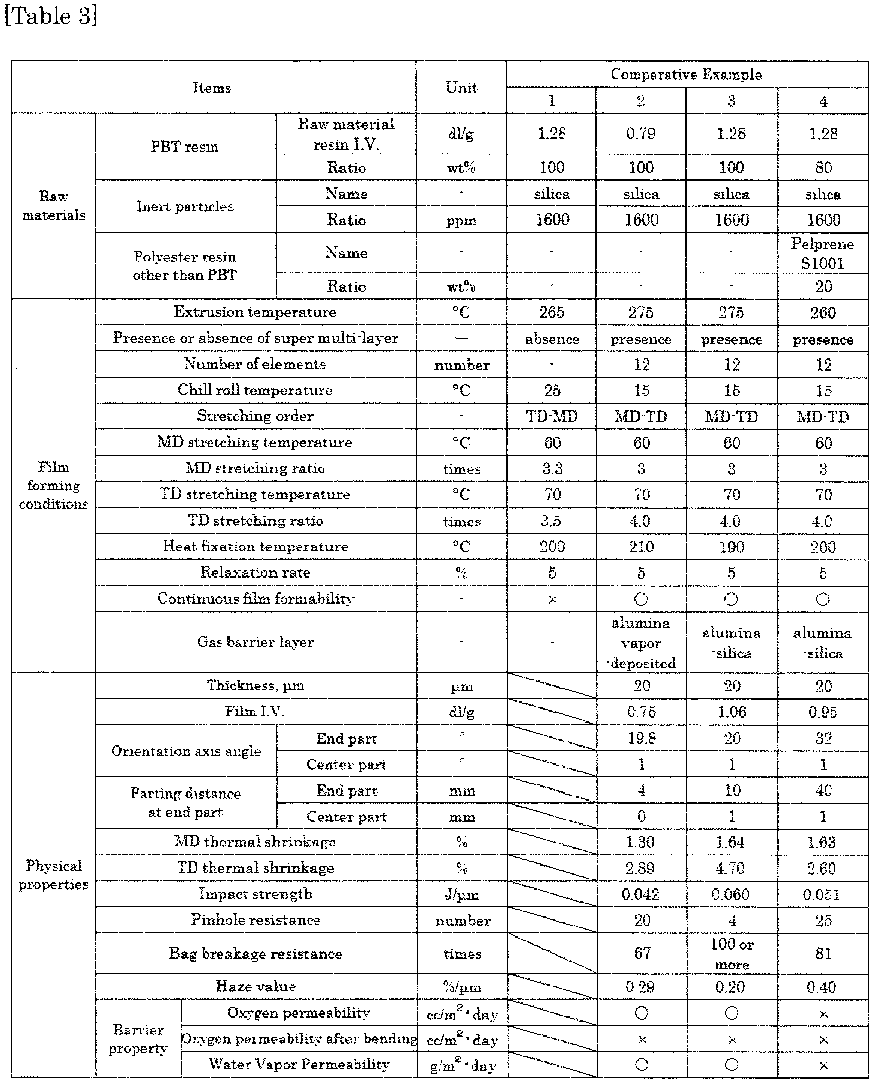

### INDUSTRIAL APPLICABILITY

The present invention can provide a gas barrier film simultaneously satisfying high gas barrier property, excellent pinhole resistance, bag breakage resistance and linearly tearing property. The gas barrier film can be widely applied as a packaging material particularly suitably used for retort pouch packaging, packaging for water containing material, and pharmaceutical packaging applications, and thus is expected to largely contribute to an industrial field.

## Claims

1. A gas barrier film comprising:
a biaxially stretched polyester film including
a thermoplastic resin composition containing not less than 60% by weight of polybutylene terephthalate and optionally containing a polyester resin other than the polybutylene terephthalate resin,
and simultaneously satisfying conditions (1) to (3) below, and
an inorganic thin film layer on at least one side of the biaxially stretched polyester film:
(1) an angle formed by a molecular chain main axis with respect to a TD direction of the film is not more than 30°,
(2) each thermal shrinkage at 150°C in the film longitudinal direction and the film width direction is not more than 4.0%, and
(3) the film has an intrinsic viscosity of not less than 0.80 dl/g and not more than 1.2 dl/g,
wherein the inorganic thin film layer on the biaxially stretched polyester film is an aluminum oxide vapor-deposited film.

2. The gas barrier film according to claim 1, wherein the polyester resin other than the polybutylene terephthalate resin is a polyethylene terephthalate, polyethylene naphthalate, polybutylene naphthalate, polypropylene terephthalate, or a polybutylene terephthalate resin copolymerized with a dicarboxylic acid.

3. The gas barrier film according to claim 2, wherein the dicarboxylic acid is an isophthalic acid, orthophthalic acid, naphthalenedicarboxylic acid, biphenyldicarboxylic acid, cyclohexanedicarboxylic acid, adipic acid, azelaic acid or sebacic acid.

## Patentansprüche

1. Ein Gassperrfilm, umfassend:
eine biaxial gestreckte Polyesterfolie einschließlich
einer thermoplastischen Harzzusammensetzung, welche nicht weniger als 60 Gew.-% Polybutylenterephthalat und gegebenenfalls ein anderes Polyesterharz als das Polybutylenterephthalatharz enthält,
und gleichzeitig die unten stehenden Bedingungen (1) bis (3) erfüllt und
eine anorganische dünne Filmschicht auf mindestens einer Seite der biaxial gestreckten Polyesterfolie:
(1) ein Winkel, der durch eine Molekülketten-Hauptachse, in Bezug auf eine TD-Richtung der Folie, gebildet wird, nicht mehr als 30° beträgt,
(2) jede thermische Schrumpfung bei 150° C in Längsrichtung der Folie und Breitenrichtung der Folie nicht mehr als 4,0 % beträgt und
(3) die Folie eine intrinsische Viskosität von nicht weniger als 0,80 dl/g und nicht mehr als 1,2 dl/g aufweist,
wobei die anorganische dünne Filmschicht auf der biaxial gestreckten Polyesterfolie ein aufgedampfter Aluminiumoxidfilm ist.

2. Der Gassperrfilm gemäß Anspruch 1, wobei das Polyesterharz, das nicht das Polybutylenterephthalatharz ist, ein Polyethylenterephtalat-, Polyethylennaphthalat-, Polybutylennaphthalat-, Polypropylenterephthalat- oder ein Polybutylenterephthalatharz ist, welches mit einer Dicarbonsäure copolymerisiert ist.

3. Der Gassperrfilm gemäß Anspruch 2, wobei die Dicarbonsäure eine Isophthalsäure, Orthophthalsäure, Naphthalendicarbonsäure, Biphenyldicarbonsäure, Cyclohexandicarbonsäure, Adipinsäure, Azelainsäure oder Sebacinsäure ist.

## Revendications

1. Film barrière aux gaz comprenant :
un film de polyester étiré biaxialement comprenant
une composition de résine thermoplastique contenant au moins 60 % en poids de poly(téréphtalate de butylène) et contenant éventuellement une résine de polyester autre que la résine de poly(téréphtalate de butylène),
et satisfaisant simultanément aux conditions (1) à (3) ci-dessous, et
une couche de film mince inorganique sur au moins un côté du film de polyester étiré biaxialement:
(1) l'angle formé par l'axe principal de la chaîne moléculaire par rapport à la direction TD du film n'est pas supérieur à 30°,
(2) chaque retrait thermique à 150 °C dans la direction longitudinale du film et la direction de la largeur du film n'est pas supérieur à 4,0 %, et
(3) le film a une viscosité intrinsèque d'au moins 0,80 dl/g et d'au plus 1,2 dl/g,
dans lequel la couche de film mince inorganique sur le film de polyester étiré biaxialement est un film d'oxyde d'aluminium déposé en phase vapeur.

2. Film barrière aux gaz selon la revendication 1, dans lequel la résine de polyester autre que la résine de poly(téréphtalate de butylène) est une résine de poly(téréphtalate d'éthylène), poly(naphtalate d'éthylène), poly(naphtalate de butylène), poly(téréphtalate de propylène), ou une résine de poly(téréphtalate de butylène) copolymérisée avec un acide dicarboxylique.

3. Film barrière aux gaz selon la revendication 2, dans lequel l'acide dicarboxylique est un acide isophtalique, acide orthophtalique, acide naphtalènedicarboxylique, acide biphényldicarboxylique, acide cyclohexanedicarboxylique, acide adipique, acide azélaïque ou acide sébacique.
